# EUROPÄISCHE PATENTSCHRIFT

(11) **EP 0 667 043 B1**
(45) Veröffentlichungstag und Bekanntmachung des Hinweises auf die Patenterteilung: **14.05.1997**
(21) Anmeldenummer: 93923563.6
(22) Anmeldetag: 27.10.1993
(51) Int. Cl.: H01M 8/02, H01M 8/24, C23C 16/04

(54) **VERFAHREN ZUM DICHTEN VON HOCHTEMPERATUR-BRENNSTOFFZELLEN UND NACH DEM VERFAHREN GEDICHTETE BRENNSTOFFZELLE**
PROCESS FOR SEALING HIGH-TEMPERATURE FUEL CELLS AND FUEL CELLS SEALED ACCORDING TO THIS PROCESS
PROCEDE PERMETTANT DE RENDRE ETANCHES DES PILES A COMBUSTIBLE A TEMPERATURE ELEVEE ET PILES A COMBUSTIBLE RENDUES ETANCHES SELON LEDIT PROCEDE

(30) Priorität: 28.10.1992 DE 4236441; 20.09.1993 DE 4331912
(43) Veröffentlichungstag der Anmeldung: 16.08.1995
(73) Patentinhaber: SIEMENS AKTIENGESELLSCHAFT, 80333 München (DE)
(72) Erfinder: PAL, Uday, Needham, MA 02194 (US); LANDES, Harald, D-90607 Rückersdorf (DE); GREINER, Horst, D-91301 Forchheim (DE)
(86) Internationale Anmeldenummer: EP9302982
(87) Internationale Veröffentlichungsnummer: WO9410717

(56) Entgegenhaltungen:
- EP-A- 0 194 373
- EP-A- 0 355 420
- EP-A- 0 425 939
- GB-A- 1 275 044
- JOURNAL OF POWER SOURCES. Bd. 10, Nr. 1 , 1983 , LAUSANNE CH Seiten 89 - 102 W. FEDUSKA ET AL 'HIGH-TEMPERATURE SOLID OXIDE FUEL CELL - TECHNICAL STATUS'
- PATENT ABSTRACTS OF JAPAN vol. 12, no. 153 (E-607)(3000) 11. Mai 1988 & JP,A,62 268 063 (MITSUBISHI HEAVY IND LTD) 20. November 1987
- PATENT ABSTRACTS OF JAPAN vol. 13, no. 114 (E-730)(3462) 20. März 1989 & JP,A,63 285 877 (MITSUBISHI HEAVY IND LTD) 22. November 1988
- CHEMICAL ABSTRACTS, vol. 115, no. 24, 16. Dezember 1991, Columbus, Ohio, US; abstract no. 259905g, MARUYAMA ET AL 'Solid-electrolyte fuel cells with gas seals between electrodes and separators'

## Beschreibung

Die Erfindung bezieht sich auf ein Verfahren zum Dichten von Undichtigkeiten der zwischen den einzelnen Bauteilen von Hochtemperatur-Brennstoffzellen befindlichen Gasraume und/ oder Gaskanäle sowie eine nach diesem Verfahren gedichtete Brennstoffzelle.

Hochtemperatur-Brennstoffzellen - auch Solid Oxide Fuel Cell (SOFC) genannt - eignen sich infolge der relativ hohen Betriebstemperaturen - sie liegen im Bereich von 800 bis 1100 °C - dazu, außer Wasserstoffgas und Kohlenmonoxid auch Kohlenwasserstoffe, wie zum Beispiel Erdgas oder flüssig speicherbares Propan, mit Sauerstoff oder Luftsauerstoff umzusetzen. Wird dem Brennstoff Wasserdampf zugesetzt, so kann bei den hohen Temperaturen jede Rußbildung vermieden werden.

Bei bekannten Hochtemperatur-Brennstoffzellen werden temperaturbedingt feste Elektrolyte eingesetzt. Hierzu ist es bekannt, im wesentlichen aus Zirkonoxid und geringen Zusätzen von Yttrium bestehende dünne Festelektrolytplattchen zwischen den Elektroden einzusetzen. Die Elektroden, das heißt die Anode und die Kathode, liegen auf gegenüberliegenden Seiten am Elektrolyten an bzw. sind auf diesem aufgesintert. Dabei besteht zum Beispiel die Anode aus einem porösen Nickel-Zirkonoxid-Cermet und die Kathode aus einer oxidischen Verbindung aus Lanthan, Strontium und Mangan. Die Elektroden bedecken die beiden Seiten der Elektrolytplättchen mit Ausnahme eines schmalen Randbereichs. Außen an den beiden Elektroden liegen sogenannte bipolare Platten bzw. Endplatten an, die aus einem gut elektrisch leitenden Material bestehen und Versorgungskanäle, sogenannte Rillenfelder, für die Zuleitung des sauerstoffhaltigen Gases an die Kathode und des Brennstoffes an die Anode sowie der Abführung des Oxidationsproduktes aufweisen. Diese meist plattenförmigen Bauelemente kontaktieren die Elektroden und stützen dabei mit den Rändern der Rillen die Elektroden der Elektrolytplättchen ab. Oft sind sie an ihren Rändern mit Durchbrüchen zur Gaszuleitung und Gasableitung versehen. Im Bereich dieser Randzonen der bipolaren Platten sind die Elektrolytplättchen mit einem Rahmen aus einem elektrisch nicht leitenden Material umgeben, der die gleiche Stärke hat wie die Elektrolytplättchen. Dieser Rahmen tragt Durchbrüche, die deckungsgleich mit den Durchbrüchen im Randbereich der bipolaren Platte sind. Zwischen den bipolaren Platten und dem Elektrolytplättchen sind sogenannte Fensterfolien eingesetzt. Diese besitzen fensterförmige Durchbrüche, an deren Rändern die freien - nicht mit Elektroden belegten - Ränder der Festelektrolytplättchen anliegen. Außerdem besitzen die Fensterfolien an ihren Rändern Durchbrüche, die zu den Durchbrüchen der bipolaren Platte deckungsgleich angeordnet sind. Die Fensterfolien bestehen aus dem gleichen Material wie die bipolaren Platten. Sie haben in etwa die Stärke der auf den Elektrolytplättchen aufgesinterten Elektroden und dienen dazu, die Elektrolytplättchen mitsamt den Elektroden und den sie umgebenden Rahmen über die jeweiligen Randbereiche gasdicht miteinander zu verbinden. Zugleich dichten die Fensterfolien über den Rand der Elektrolytplättchen und über den die Elektrolytplättchen umgebenden Rahmen die anoden- und kathodenseitigen Gasräume gegeneinander und zu den Durchbrüchen im Rahmen ab. Der die Elektrolytplättchen umgebende Rahmen, die bipolaren Platten und die Fensterfolien sind bei bekannten Hochtemperatur-Brennstoffzellen unter Zwischenschaltung eines über der Betriebstemperatur schmelzenden Lotes miteinander gasdicht verlötet.

Die einzelnen Gasräume bzw. Gaskanäle zu beiden Seiten des Elektrolyten müssen sowohl nach außen hin als auch untereinander gasdicht abgedichtet sein. Dies ist unter anderem deshalb erforderlich, damit sich nicht Brennstoff und Sauerstoff vermischen und einen chemischen Kurzschluß bilden, der den Gesamtwirkungsgrad herabsetzt und außerdem wegen der Wasserstoffverbrennung zu örtlichen Überhitzungen führen würde. Die Abdichtung ist darüber hinaus auch erforderlich, um Schäden an den Elektroden zu vermeiden, die sonst in Gegenwart des jeweils anderen Reaktionsgases zerstört werden würden.

Aus dem Artikel "High temperature solid oxide fuel cell - Technical status" in Journal of Power Source, Bd. 10, Nr. 1, 1983, Seiten 89 bis 102 ist ein Verfahren abgebildet, bei dem sehr allgemein dargestellt, poröse Substrate mittels der bekannten Verfahren des CVD und EVD gasdicht versiegelt werden.

Der Erfindung liegt daher die Aufgabe zugrunde, einen Weg zu weisen, wie die Dichtigkeit von Brennstoffzellen mit möglichst wenig Aufwand verbessert werden kann.

Diese Aufgabe wird durch die Merkmale des Anspruchs 1 und 24 gelöst. Weitere vorteilhafte Ausgestaltungen der Erfindung sind den Ansprüchen 2 bis 23 und 25 zu entnehmen.

Indem mindestens zwei verschiedene Gase verwendet werden, von denen das erstere zumindest eine zu einem metallionenleitenden und/oder sauerstoffionenleitenden Oxid aufoxidierbare gasförmige Verbindung enthält und das zweite sowie gegebenenfalls weitere Gase Sauerstoff enthalten bzw. abgeben können und die verschiedenen gegeneinander und nach außen abzudichtenden Gasräume und/oder Gaskanäle der Hochtemperatur-Brennstoffzellen bei hoher Temperatur erfindungsgemäß dergestalt mit dem ersten, zweiten und/oder weiteren Gas beaufschlagt werden, daß jede Undichtigkeit auf der einen Seite mit dem ersten Gas und auf der anderen Seite mit dem zeiten oder weiteren Gas umspült wird, wird ein Weg gewiesen, wie einzelne undichte oder undicht gewordene Brennstoffzellen oder auch Stapel von Brennstoffzellen ohne vorherige Demontage noch nachträglich gedichtet werden können. Dabei ist es ein besonderer Vorteil, daß die Materialablagerungen, die schließlich zur Abdichtung führen, gerade nur an jenen Stellen erfolgen, an denen sich Undichtigkeiten befinden und über die die verschiedenen Gase miteinander in Kontakt kommen. In den Fällen, in denen ein sauerstoffionenleitendes Oxid gebildet wird, können auch nach dem Schließen der Undichtigkeit durch eine monomolekulare Schicht des Oxids immer noch Sauerstoffionen durch die Schicht durchtreten und auf der gegenüberliegenden Seite der ehemaligen Undichtigkeit weitere Gasreaktionen und damit ein weiteres Anwachsen der Schicht mit abnehmender Geschwindigkeit bewirken. Dies gilt analog für die andere Seite der Undichtigkeit, wenn ein metallionenleitendes Oxid erzeugt wird. Dabei enthält das erste Gas mindestens eine oxidierbare, gasförmige Verbindung eines oder mehrerer der Metalle des Elektrolytmaterials, der bipolaren Platte, der Elektroden der Brennstoffzelle und/oder eines der Elemente Zirkon, Nikkel, Kalzium, Magnesium, Cer oder Seltenes Erdmetall.

Eine solche nach dem obigen Verfahren gedichtete Hochtemperatur-Brennstoffzelle weist erfindungsgemäß gerade an den vormals undichten Stellen zwischen den einzelnen Bauteilen Einlagerungen aus metallionenleitenden und/oder sauerstoffionenleitenden Oxiden auf, die diese Undichtigkeiten abgedichtet haben. Diese Schichten bauen sich infolge des Kontaktes des ersten mit dem zweiten Gas gerade an den Stellen auf, wo infolge von Undichtigkeiten - etwa in Spalten oder Poren - diese verschiedenen Gase miteinander in Berührung kommen und die gasförmigen Verbindungen der Metalle oxidieren. Diese Einlagerungen können mit den Wänden der Undichtigkeiten versintern und somit auch das Lot zwischen den einzelnen Bauteilen ersetzen.

Solche Verbindungen erfüllen die Voraussetzungen, daß sie sich in Gegenwart des zweiten sauerstoffhaltigen Gases zersetzen und feste sauerstoffionenleitende und/oder metallionenleitende Metalloxide bilden, die sich niederschlagen, mit dem Untergrund verbinden und die Risse und Spalten auf diese Weise dichten. Durch diese Maßnahme wird auch erreicht, daß sich in den Poren und Kanälen, die für die Undichtigkeit ursächlich sind, Oxide bilden, die hinsichtlich ihres Ausdehnungskoeffizienten mit dem Umgebungsmaterial übereinstimmen und hinsichtlich ihrer chemischen Beständigkeit an die in der Brennstoffzelle herrschenden physikalischen Bedingungen angepaßt sind. Dies ist deshalb so wichtig, weil das in Spalten und Kanälen eingelagerte Material im Falle unterschiedlicher Ausdehnungskoeffizienten bei den sehr hohen Temperaturunterschieden, die bei Brennstoffzellen beim Einschalten und Wiederausschalten durchlaufen werden und die von der Zimmertemperatur bis 1000 °C reichen, sonst mechanische Spannungen erzeugt werden, die die Undichtigkeiten weiter vergrößern könnten.

Es hat sich als besonders zweckmäßig erwiesen, wenn in Ausgestaltung der Erfindung den verschiedenen Gasen zur Einstellung der Reaktivität ein Inertgas, wie etwa Stickstoff (N₂), oder ein Edelgas beigemischt ist.

In besonders vorteilhafter Weiterbildung der Erfindung kann die Brennstoffzelle von außen mit dem ersten Gas umflutet und kathodenseitig mit dem zweiten und anodenseitig mit dem weiteren Gas durchströmt werden. Auf diese Weise lassen sich alle nach außen führenden Undichtigkeiten abdichten.

Um Schäden an der Anode zu vermeiden, ist es in Ausgestaltung der Erfindung angezeigt, die Brennstoffzelle anodenseitig mit Wasserdampf oder mit einem Wasserdampf-Wasserstoff-Gasgemisch als weiterem Gas zu beaufschlagen. Die Sauerstoffaktivität dieses Gases reicht einerseits aus, um die Oxidation der gasförmigen Metallverbindungen des ersten Gases vorzunehmen. Zum anderen jedoch beläßt es die Nickelteilchen der Anoden im metallischen Zustand.

Alternativ wäre es auch möglich, die Brennstoffzelle in Ausgestaltung der Erfindung anodenseitig mit einem kohlenmonoxid- und/oder kohlendioxidhaltigem Gas als weiterem Gas zu beaufschlagen. Auch diese Gase sind in der Lage, bei hohen Verfahrenstemperaturen eine ausreichende Menge Sauerstoffaktivität einzustellen, so daß die gasförmige Metallverbindung des ersten Gases oxidiert werden kann, ohne gleichzeitig die Anoden durch Oxidation zu zerstören.

In einer anderen Weiterbildung der Erfindung kann die Brennstoffzelle anodenseitig mit dem ersten Gas und kathodenseitig mit dem zweiten Gas beaufschlagt werden. Auf diese Weise können auch alle Undichtigkeiten zwischen den betriebsmäßig Sauerstoff und den betriebsmäßig Brennstoff führenden Gasräumen und/oder Kanälen abgedichtet werden. Dabei ist von Bedeutung, daß das erste Gas anodenseitig und nicht etwa kathodenseitig zugeführt wird. So kann die Anode vor unerwünschter Oxidation bewahrt werden.

Es hat sich als vorteilhaft erwiesen, wenn das zweite Gas Sauerstoff enthält, dem zur Abschwächung seiner oxidativen Wirkung eines oder mehrere der Komponenten Wasserdampf, Edelgas und Stickstoff zugemischt sind. Auf diese Weise lassen sich bei Durchführung des Verfahrens unerwünschte Reaktionen mit dem Material der Wände vermeiden.

In vorteilhafter Ausgestaltung der Erfindung kann die aufoxidierbare gasförmige Metallverbindung des ersten Gases eine Halogenverbindung sein. Halogenverbindungen haben die Eigenschaft, daß sie bei der Verfahrenstemperatur in Gegenwart von Sauerstoff zersetzt und in feste Metalloxidverbindungen umgewandelt werden können.

Es hat sich als sehr zweckmäßig erwiesen, wenn in Weiterbildung der Erfindung im Bereich der zu dichtenden Anlageflächen zwischen den einzelnen Bauteilen vor dem Zusammenbau eine Mischung von Zirkonoxid und Nickel und/oder ein elektronisch besser als Zirkonoxid leitendes Oxid und/oder eine Vorstufe dazu und einem Additiv eingebracht wird und die zusammengebaute Brennstoffzelle bzw. Brennstoffzellenstapel vor bzw. während der Beaufschlagung mit dem ersten, zweiten und weiteren Gas auf Sintertemperatur aufgeheizt wird. Durch diese Maßnahme wird erreicht, daß zwischen den zu dichtenden Anlageflächen der Bauteile eine dünne keramische Schicht definierter Porigkeit entsteht, die alle Spalten ausfüllt und ideale geometrische Voraussetzungen für den eigentlichen Abdichtvorgang liefert.

Die Montage der Brennstoffzelle wird bedeutend vereinfacht, wenn in Ausgestaltung der Erfindung eine hinsichtlich Form und Abmessungen deckungsgleiche, Zirkonoxid und Nickel und/oder ein elektronisch besser als Zirkonoxid leitendes Oxid bzw. eine Vorstufe dazu und eine ein Additiv enthaltende Grünfolie zwischen den zu dichtenden Anlageflächen vor dem Zusammenbau eingelegt wird. Auf diese Weise können Verstopfungen der Gaskanäle recht zuverlässig vermieden werden.

Es hat sich als besonders vorteilhaft herausgestellt, wenn in Weiterbildung der Erfindung der Gasdruck bei Durchführung des Verfahrens auf etwa 10⁻³ bis 10⁻⁵ bar eingestellt wird. Dies hat zur Folge, daß die freie Weglänge der Gasmoleküle etwa 100 µm beträgt. Dieser Wert liegt über dem Porendurchmesser der mit der zwischen die Dichtflächen eingebrachten Mischung erzeugten Poren. Hierdurch wird eine bessere Haftung des eingelagerten Materials in die Undichtigkeiten erreicht.

Des weiteren hat es sich als besonders zweckmäßig erwiesen, wenn in Ausgestaltung der Erfindung zeitweise der Gasdruck des ersten Gases höher ist als der des zweiten bzw. weiteren Gases und umgekehrt. Hierdurch können die beiden Gase, insbesondere wenn die Druckdifferenz die Richtung wechselt, besser abwechselnd in die Spalten der Undichtigkeiten gedrückt werden. Dadurch kann die Begegnung dieser Gase im wesentlichen in den Spalten und Schlitzen stattfinden.

Weitere Einzelheiten der Erfindung werden anhand eines Ausführungsbeispiels näher erläutert. Es zeigen:
Figur 1 eine Explosionszeichnung eines Brennstoffzellenstapels mit zwei in Serie geschalteten Hochtemperatur-Brennstoffzellen,
Figur 2 eine schematische Darstellung dreier Undichtigkeiten im Bereich der Lötstellen zwischen einer bipolaren Platte, einer Fensterfolie und dem Elektrolyten einer Hochtemperatur-Brennstoffzelle,
Figur 3 eine schematisierte Darstellung von zwei Undichtigkeiten im Bereich eines vertikal durch die Ebenen der bipolaren Platte, Fensterfolie und Elektrolytrahmen verlaufenden Gasverteilungskanals (manyfolding channel) und
Figur 4 eine schaubildliche Ansicht einer Grünfolie mit ausgestanzten Gaskanälen.

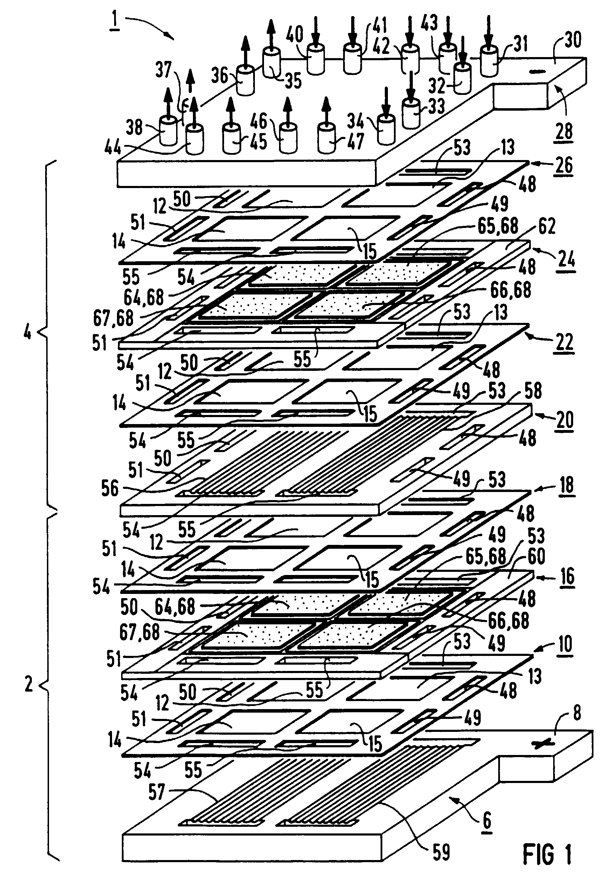

In der in Figur 1 gezeigten Explosionszeichnung eines Stapels 1 mit zwei in Serie geschalteten Hochtemperatur-Brennstoffzellen erkennt man von unten nach oben gesehen eine untere Deckplatte 6 mit seitlich herausgeführter positiver Kontaktzunge 8, eine Fensterfolie 10 mit vier Fensterdurchbrüchen 12, 13, 14, 15, einen Festelektrolytrahmen 16 mit vier eingelegten Festelektrolytplättchen 64, 65, 66, 67, eine weitere Fensterfolie 18, eine bipolare Platte 20, eine weitere Fensterfolie 22, einen weiteren Festelektrolytrahmen 24 mit eingelegtem Festelektrolytplättchen, eine weitere Fensterfolie 26 und eine obere Deckplatte 28 mit seitlich herausgeführter negativer Kontaktzunge 30. Außerdem trägt die obere Deckplatte 28 sechzehn Anschlußstutzen 31 bis 38 und 40 bis 47 für die Zuführung und Abführung von brennstoff- und sauerstoffhaltigem Gas. Mit Ausnahme der beiden Deckplatten 6, 28 besitzen sämtliche Fensterfolien 10, 18, 22, 26 Festelektrolytrahmen 16, 24 und die bipolare Platte 18 im Randbereich längliche Durchbrüche 48 bis 55, die im zusammengebauten Stapel 1 zueinander fluchten und zusammen in Richtung der Normalen zur Plattenebene, das heißt vertikal durch den Stapel 1, gehende Gaskanäle - auch "manyfolding channel" genannt - bilden, in die die Anschlußstutzen 31 bis 38, 40 bis 47 der oberen Deckplatte 28 münden.

Die bipolare Platte 20 in der Mitte des Stapels, die zwischen den beiden Brennstoffzellen 2, 4 des Stapels angeordnet ist, besitzt im Ausführungsbeispiel auf ihrer oberen Seite zwei Rillenfelder 56, 58, die je einen der beiden vorderen Durchbrüche 54, 55 mit einem gegenüberliegenden hinteren Durchbruch 52, 53 im Randbereich der bipolaren Platte 20 verbindet. Auf der Unterseite ist die bipolare Platte 20 ähnlich aufgebaut, nur daß die beiden Rillenfelder um 90° gegenüber der Oberseite verdreht sind und die Durchbrüche 48, 49 auf der rechten Seite mit jenen Durchbrüchen 50, 51 auf der linken Seite der bipolaren Platte verbinden. Auch die obere und die untere Deckplatte 6, 28 sind auf der Seite der Fensterfolie 10, 26 mit zwei solchen Rillenfeldern 57, 59 (nur zwei sichtbar) versehen, die genauso ausgerichtet sind wie die Rillenfelder auf der gleichen unteren oder oberen Seite der bipolaren Platte 20. Die Fensterdurchbrüche 12, 15 in den Fensterfolien 10, 18, 22, 26 sind über die einzelnen Rillenfelder der bipolaren Platte 20 angeordnet. Die Fensterfolien, die bipolare Platte und die beiden Deckplatten 6, 28 bestehen aus der gleichen elektrisch gut leitenden Metallegierung, die außerdem auch einen an den Festelektrolyten angepaßten Ausdehnungskoeffizienten besitzt. Dies sind üblicherweise Legierungen eines oder mehrerer der Elemente Chrom, Eisen und/ oder Nickel. Anstelle der Metallegierung wären auch elektrisch gut leitende und gasdicht sinterbare Keramiken, wie zum Beispiel Lanthanchromit, verwendbar.

Die Festelektrolytrahmen 16, 24 bestehen im Ausführungsbeispiel aus Zirkonoxid. In ihnen sind gegenüber den vier Fensterdurchbrüchen 12, 13, 14, 15 der Fensterfolien jeweils vier rechteckige Festelektrolytplättchen 64, 65, 66, 67 aus Yttrium stabilisiertem Zirkonoxid eingesetzt. Letztere sind im Ausführungsbeispiel auf ihrer Oberseite mit Ausnahme eines schmalen umlaufenden Randbereichs mit einer Lanthan-Strontium-Manganoxid-Verbindung als Kathodenmaterial 68 und auf ihrer Unterseite entsprechend mit einem Nickel-Zirkonoxid-Cermet als Anodenmaterial 70 beschichtet. Mit ihren Randbereichen liegen die Festelektrolytplättchen beidseitig auf den Fensterrändern der Fensterfolien auf, wobei das Elektrodenmaterial die durch die Fensteröffnungen definierten Volumina ausfüllt. Der Flügelspalt zwischen dem freien Rand der Festelektrolytplättchen und der jeweils anliegenden Fensterfolie ist im Ausführungsbeispiel durch ein auch noch bei Betriebstemperatur, das heißt bei über 1100 °C, starres Lot 72 verschlossen. Beim Zusammenbau dieser einzelnen Bausteine 6, 10, 16, 18, 20, 22, 24, 26, 28 zu einem Brennstoffzellenstapel 1 werden die einzelnen plattenförmigen Bauteile in dem die Durchbrüche umschließenden Randbereich mittels dieses Lots 72 gasdicht miteinander verlötet.

Beim Betrieb einer solchen Brennstoffzelle 2, 4 werden auf der einen Stirnseite der bipolaren Platte 20 - im Ausführungsbeispiel der Figur 1 ist das die hintere Stirnseite des Stapels 1 - sauerstoffhaltiges Gas, etwa Luft, durch die Anschlußstutzen 40 bis 43 und die darunter fluchtend angeordneten Durchbrüche 52, 53 in den einzelnen plattenförmigen Bauelementen 10, 16, 18, 20, 22, 24, 26 eingeführt und auf der gegenüberliegenden vorderen Seite durch die Durchbrüche 54, 55 und Anschlußstutzen 45 bis 47 wieder abgeführt. Zugleich wird auf der - im Ausführungsbeispiel der Figur 1 rechten Stirnseite des Stapels 1 - Brennstoff, im wesentlichen wasserstoffhaltiges Gas, durch die Anschlußstutzen 31 bis 34 und die darunterliegenden Durchbrüche 48, 49 eingeführt und auf der dazu gegenüberliegenden linken Stirnseite dieses wasserstoffhaltige Gas sowie das Oxidationsprodukt Wasserdampf durch die Durchbrüche 50, 51 und die Anschlußstutzen 35 bis 38 wieder abgeführt. Dabei strömt das sauerstoffhaltige Gas längs der Rillenfelder 57, 59 an der Unterseite der Deckplatte 28 und der Unterseite der bipolaren Platte längs der mit Kathodenmaterial 68 beschichteten Seite der Elektrolytplättchen 64, 65, 66, 67 entlang und strömt das wasserstoffhaltige Gas längs der Oberseite der unteren Deckplatte 6 und der Rillenfelder 56, 58 an der Oberseite der bipolaren Platte 20 und an den mit Anodenmaterial 70 beschichteten Seiten der Elektrolytplättchen 64, 65, 66, 67 entlang. Die sich bildende elektromotorische Kraft der beiden in Serie geschalteten Brennstoffzellen kann dann an den Kontaktzungen 8, 30 der beiden Deckplatten 6, 28 abgegriffen werden.

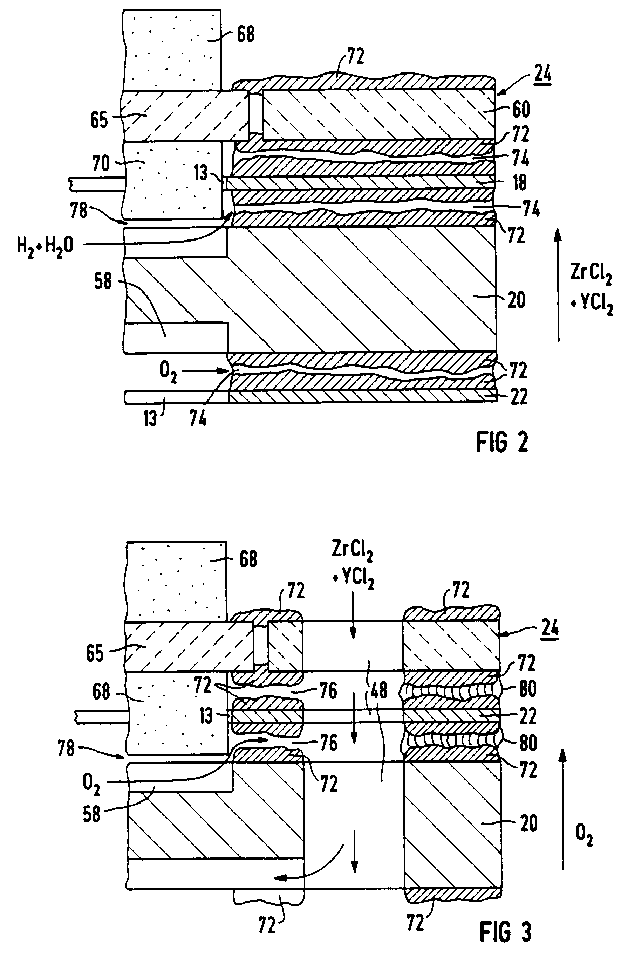

Die Figur 2 zeigt einen stark vergrößerten Ausschnitt des Randbereichs der bipolaren Platte 20 und der beiden unmittelbar anliegenden Fensterfolien 18, 22 und einer an der einen Fensterfolie 18 anliegenden Festelektrolytplatte 24. In der stark schematisierten Zeichnung erkennt man im Bereich der Fügestellen zwischen den plattenförmigen Bauelementen aufgeschnittene, schematisierte Spalten, die Leckstellen 74 im Bereich des Lotes 72 darstellen sollen. Zur Dichtung dieser Leckstellen ist die Brennstoffzelle 2 in einem - hier nicht weiter dargestellten - evakuierbaren und vorzugsweise beheizbaren Gefäß gestellt. Sie wird nun anodenseitig mit einem Wasserstoff-Stickstoffgasgemisch und kathodeneitig mit einem Sauerstoff-Stickstoffgasgemisch - etwa mit Luft - gespült. Die Temperatur der Brennstoffzelle 2, 4 wird sodann durch Aufheizen der zunächst unter Atmosphärendruck zugeführten Spülgase auf Verfahrenstemperatur, das heißt auf ca. 900 bis 1100 °C, erhöht. Nach Erreichen der Verfahrenstemperatur wird der Druck der Gase auf 10⁻³ bis 10⁻⁵ bar eingestellt. In den anodenseitigen Gaskanälen und Gasräumen der Brennstoffzelle wird nunmehr außer Wasserstoff auch Wasserdampf eingeleitet. Die Gaszusammensetzung in den ohnedies sauerstofführenden kathodenseitigen Gaskanälen braucht an sich nicht geändert zu werden. In das evakuierbare Gefäß wird ein Gas eingeleitet, das eine zu einem metallionenleitenden und/oder sauerstoffionenleitenden Oxid aufoxidierbare gasförmige Verindung vorzugsweise eines oder mehrerer der Metalle des Elektrolytmaterials, der bipolaren Platte 20 oder der Elektroden enthält. Im Ausführungsbeispiel wird ein Gasgemisch von Zirkonchlorid und Yttriumchlorid verwendet. Um die Reaktionsgeschwindigkeit zu steuern, können alle genannten Gase mit einem Inertgas - im vorliegenden Fall Stickstoff - weiter verdünnt werden. Die Sauerstoffaktivität des Wasserdampfs oder des Wasserdampf-Wasserstoffgemisches genügt zur Oxidation des Zirkonchlorids. Sie ist andererseits wiederum auch nicht so stark, daß dadurch die Anode geschädigt bzw. die Nickelteilchen der Anode oxidiert werden. Andererseits soll auch - solange die Brennstoffzelle noch nicht gedichtet ist - die Sauerstoffaktivität des Wasserstoff-Wasserdampfgemisches eventuell durch Zugabe von Inertgas so eingestellt werden, daß keine schädliche Reduktion der Kathoden erfolgen kann.

Soweit der Druck innerhalb und außerhalb der Brennstoffzelle 2, 4 gleich ist, diffundieren nun die Gase vom Inneren der Brennstoffzelle durch die Leckstellen 74 des Lotes 72 nach außen und diffundiert das außerhalb der Brennstoffzelle befindliche Gas durch eben diese Leckstellen nach innen. Die beiden Gase treffen dabei in den Leckstellen aufeinander. Bei der Temperatur von ca. 1000 °C reagiert Sauerstoff, der sowohl aus den kathodenseitigen als auch aus den anodenseitigen Gasräumen und Kanälen von innen nach außen strömt, mit den gasförmigen Verbindungen der Metalle, die von außerhalb der Brennstoffzelle zuströmen - im Ausführungsbeispiel mit Zirkonchlorid und Yttriumchlorid -, und bilden die entsprechenden Metalloxide - im vorliegenden Fall Zirkonoxid und Yttriumoxid -, welche in den Leckstellen an den Oberflächen aufwachsen.

Durch den abgesenkten Gasdruck wird die mittlere freie Weglänge der Gasatome soweit erhöht, daß die Reaktion hauptsächlich im Bereich der Oberflächen der Fügespalte bzw. der Undichtigkeiten stattfindet. Auf diese Weise wird eine gute Haftfestigkeit des Metalloxidauftrags auf den inneren Oberflächen der Undichtigkeiten erreicht.

Die Abscheidung der schließlich dichtenden Metalloxide in den Fügespalten wird im Ausführungsbeispiel dadurch weiter beschleunigt, daß eine nach Betrag und Richtung zeitweise wechselnde Druckdifferenz zwischen den beiden Gasräumen eingestellt wird. Dies geschieht im Ausführungsbeispiel dadurch, daß der Gasdruck im Außenraum und Innenraum abwechselnd stufenweise erhöht wird. Diese Schwankungen können durch zeitweiliges abwechselndes Androsseln bzw. Verringern der Saugleistung der Vakuumpumpe für die beiden Gasräume bei gleichzeitiger unveränderter Gaszuführung erzielt werden. Dabei ist die Frequenz dieser Druckschwankungen zweckmaßigerweise so kurz zu bemessen, daß die Zeit nicht ausreicht, daß nennenswerte Mengen der Gase durch die Leckstellen bis auf die gegenüberliegende Seite derselben hindurchströmen. Hierfür kann man unter anderem, je nach Leckquerschnitt und Druckdifferenz, Zeiten bis 1 und 100 Sekunden ansetzen. Somit ergeben sich Druckschwankungsfrequenzen in der Größenordnung von 1 bis 0,01 Hz.

Sobald alle Leckstellen, die vom Inneren der Brennstoffzelle nach außen führen, geschlossen sind, klingt der Stoffumsatz und damit die Abscheidungsrate des ionenleitenden Metalloxids allmählich ab. Sie ist bei bereits geschlossenem Leck nur noch durch die mit Wachsen der Schichtdicke des abgelagerten Metalloxids abnehmende Ionenleitung der Schicht bestimmt. Daher kann die Behandlungsdauer ohne weitere Nachteile reichlich lang bemessen werden. Leckstellen, die zwischen Gaskanälen im Innern der Brennstoffzelle vorhanden sein können, werden dadurch jedoch nicht geschlossen. Wie dies zu geschehen hat, wird anhand der Figur 3 gezeigt.

Die Figur 3 zeigt einen vergrößerten Ausschnitt zwischen einem vertikal - das heißt in Richtung der Normalen auf die plattenförmigen Bauelemente des Stapels 1 - durch die Durchbrüche 48 gehenden Gaskanal, der betriebsmäßig wasserstoffhaltiges Gas durch den Brennstoffzellenstapel durchleiten soll, und einen im wesentlichen aus dem Rillenfeld 58 bestehenden Gasraum 78 im Inneren der Brennstoffzelle 2, der betriebsgemäß sauerstoffhaltiges Gas führt. In der Figur 3 sind zwischen der Fensterfolie 22 und der auf der einen Seite anliegenden bipolaren Platte 20 sowie auf der anderen Seite anliegenden Festelektrolytplatte 24 im Bereich des Lotes 72 Leckstellen 76 zwischen dem durch den Durchbruch 48 führenden Gaskanal und dem inneren Gasraum 78 der Brennstoffzelle 2 eingezeichnet.

Um diese Leckstellen zu dichten, wird die Brennstoffzelle in einen evakuierbaren und vorzugsweise heizbaren Rezipienten gestellt und, wie anhand des Ausführungsbeispiels der Figur 2 erläutert, über aufgeheizte Spülgase auf Verfahrenstemperatur, das heißt auf ca. 1000 °C, aufgeheizt. Sodann wird der Rezipient und die Gaskanäle und Gasräume auf ca. 10⁻⁴ bar evakuiert. Nunmehr wird durch die Gaskanäle, die sonst betriebsgemäß wasserstoffhaltiges Gas führen, ein im Ausführungsbeispiel zirkonchlorid- und yttriumchloridhaltiges Gas, geleitet. Die übrigen Gaskanäle und/oder Gasräume werden mit einem sauerstoffhaltigen Gas, etwa Luft, gefüllt. Wie anhand der Figur 2 gezeigt, kann die Reaktivität dieser Gase durch Zuführen eines Inertgases eingestellt werden. Nunmehr treffen sich die sauerstoffhaltigen Gase aus dem Gasraum 78 und das zirkonchlorid- und yttriumchloridhaltige Gas aus dem Gaskanal 48 in den Leckstellen 76 zwischen diesen beiden Gasräumen und dichten diese Leckstellen in der gleichen Weise ab, wie das anhand der Figur 2 erläutert wurde. Das gleiche passiert in den Leckstellen zwischen den betriebsgemäß sauerstoffhaltiges Gas führenden Gasräumen und Brennstoff führenden benachbarten Gaskanälen, das heißt insbesondere in den Leckstellen zwischen den Festelektrolytplättchen 64 bis 67, den anliegenden Fensterfolien und den Festelektrolytrahmen. Auch hier ist es hilfreich, wenn die Drücke der beiden Gase zeitweise relativ zueinander abwechselnd erhöht und abgesenkt werden.

Es ist ein großer Vorteil des beschriebenen Verfahrens, daß sich damit ohne Demontage von Brennstoffzellen feinste Spalten, Poren, Lecks oder sonstige Undichtigkeiten 74, 76 zwischen den einzelnen Bauelementen der Brennstoffzelle sowohl solche, die nach außen führen, also auch solche, die im Inneren der Brennstoffzelle zwischen verschiedenen Gasräumen bestehen, schließen lassen. Da ein Stoffumsatz nur im Bereich der Leckstellen stattfindet, können fertig montierte Brennstoffzellen sogar vorsorglich, das heißt auf den bloßen Verdacht hin, einer solchen Behandlung unterworfen werden. Dabei ist es keineswegs erforderlich, daß sich diese Undichtigkeiten im Bereich des Lotes befinden. Vielmehr kann so auch eine nicht vorgelotete Brennstoffzelle, bei der die einzelnen Bauelemente im losen mechanischen Kontakt aufeinander liegen oder aufeinandergepreßt sind, auf diesem Wege gedichtet werden. Dabei wird eine mechanisch stabile, gasdichte Fügung der einzelnen Komponenten erreicht.

Bei nennenswerten Undichtigkeiten und insbesondere, wenn nicht verlötete Brennstoffzellen gasdicht gefügt werden sollen, empfiehlt es sich, die Anodenseite vor dem eigentlichen Dichtungsverfahren mit einem aufgeheizten Wasserstoff-Stickstoff-Gemisch und die Kathodenseite mit einem aufgeheizten Sauerstoff-Stickstoff-Gemisch, bei dem der Inertgasanteil, das heißt hier der Stickstoffanteil, stark erhöht ist, zu spülen. Damit soll erreicht werden, daß, solange die Zelle noch nicht dicht ist, Knallgasreaktionen zu keinen örtlichen Überhitzungen führen können. Die Verfahrensdauer zur Dichtung der Lecks wird größenordnungsmäßig mit einer Stunde angesetzt, wobei längere Verfahrensdauern unschädlich sind. Nach Abschluß des Verfahrens und Abkühlen der gedichteten Brennstoffzelle ist dafür zu sorgen, daß anodenseitig kein Sauerstoff und kathodenseitig kein Brennstoff eingeleitet wird.

Zum Aufheizen der Brennstoffzellen eignet sich auch eine Wirbelstromheizung. Sie kann zusätzlich zur Aufheizung mit vorgeheizten Gasen eingesetzt werden.

Abweichend von den Ausführungsbeispielen der Figuren 2 und 3 kann anstelle des Lotes eine Paste aus Zirkonoxid, Nickel und/oder einem elektronisch besser als Zirkonoxid leitenden Oxid bzw. einer Vorstufe dazu und einem rückstandslos oxidierbaren bzw. verdampfenden Additiv im Bereich der zu dichtenden Anlageflächen zwischen den einzelnen Bauteilen vor dem Zusammenbau eingebracht werden. Die zusammengebaute Brennstoffzelle bzw. der zusammengebaute Brennstoffzellenstapel wird dann vor bzw. während der Beaufschlagung mit dem ersten, zweiten und weiteren Gas auf Sintertemperatur aufgeheizt. Diese Paste führt, abweichend von dem im Ausführungsbeispiel der Figuren 2 und 3 eingebrachten Lot 72, nicht zu einer Dichtung der Spalten zwischen den einzelnen Bauteilen, sondern nach dem Aufheizen auf Sintertemperatur zu einem Verdampfen bzw. Wegoxidieren des Additivs und Versintern des Zirkonoxids und Nickels bzw. der eingebrachten Oxide bzw. deren Vorstufen zu einem die Spalten vollständig ausfüllenden porösen, keramischen Körper. Dieser kann auch mit den anliegenden Bauteilen versintern. Die so statt des Lotes eingebrachte keramische Zwischenschicht hat eine definierte Porigkeit und füllt sämtliche Unebenheiten, Spalten und Ritzen aus. Die definierte Porigkeit dieser Keramik erlaubt es, diese Poren mit dem ersten, zweiten und weiteren Gas zuverlässig zu dichten.

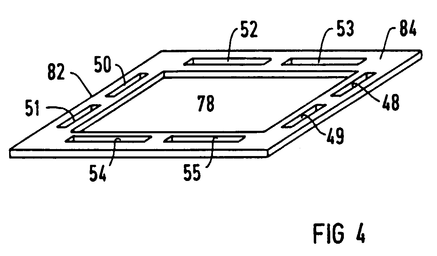

Die Figur 4 zeigt einen Rahmen 82 aus einer Grünfolie 84 bestehend aus Zirkonoxid, Nickel und/oder einem elektronisch besser als Zirkonoxid leitenden Oxid bzw. einer Vorstufe dazu und einem Additiv. Sie ist hinsichtlich ihrer Durchbrüche 48 bis 55 und ihrer inneren und äußeren Kontur deckungsgleich mit den plattenförmigen aufeinandergestapelten Bauteilen der Brennstoffzellen bzw. des Brennstoffzellenstapels, das heißt dem Rahmen 60, 62, der die Festelektrolytplättchen 64, 65, 66, 67 umschließt, der Fensterfolien 10, 18, 22, 26 und auch der bipolaren Platte 20. Als Additiv wird im Ausführungsbeispiel Polyvinylalkohol verwendet. Dieses Material hat die Eigenschaft, daß es die übrigen Bestandteile der Grünfolie bzw. Paste bei der Verarbeitung bindet und beim Aufheizen vor dem Sintern verflüchtigt bzw. rückstandslos verbrennt. Zurück bleiben die zuvor von diesem Additiv eingenommen Volumina, die wegen der vorherigen homogenen Mischung des Additivs mit den übrigen Komponenten eine gleichmäßige Porigkeit des bei der Sintertemperatur entstehenden Sinterkörpers erzeugen. Zugleich kann auch dieser Sinterkörper mit dem Festelektrolytrahmen, Fensterfolien und bipolaren Platten versintern. Er trägt dabei zur mechanischen Festigkeit der Brennstoffzelle bzw. des Brennstoffzellenstapels mit bei.

Die Grünfolie wird vor dem Zusammenbau bzw. vor der Zwischenlage zwischen den Fensterfolien und den bipolaren Platten einerseits und den Fensterfolien und dem Festelektrolytrahmen andererseits hinsichtlich ihrer inneren und äußeren Umfänge deckungsgleich mit den Durchbrüchen 48 bis 55 in den vorgenannten Bauteilen ausgestanzt. Beim Einsatz werden die ausgestanzten Grünfolien zu beiden Seiten der Fensterfolien und den an den Fensterfolien anliegenden Bauteilen, wie Festelektrolytrahmen oder bipolare Platte oder obere und untere Deckplatte, eingelegt und ersetzen das Lot bzw. die anstelle des Lotes einzubringende Paste aus Zirkonoxid, Nickel und/oder einem elektronisch besser als Zirkonoxid leitenden Oxid. Dadurch wird sichergestellt, daß die Querschnitte der Durchbrüche nicht versehentlich eingeengt oder zugeschmiert werden.

Beim Zusammenbau der Hochtemperatur-Brennstoffzelle bzw. des Hochtemperatur-Brennstoffzellenstapels mit den zwischengelegten Grünfolien 82 bleiben somit alle Durchbrüche 48 bis 55 und Gasströmungswege frei. Beim späteren Aufheizen der Brennstoffzelle oder des Brennstoffzellenstapels verdunstet und verbrennt das Additiv rückstandsfrei. Beim Erreichen der Sintertemperatur versintert das verbleibende Material der Grünfolie in sich und gegebenenfalls auch mit den anliegenden anderen Bauteilen. Die nunmehr vorliegende Brennstoffzelle bzw. der Brennstoffzellenstapel enthält jetzt nur noch eine porige keramische Struktur zwischen den zu dichten Bauteilen mit einem in engen Grenzen definierten Porendurchmesser. Dieser eignet sich vorzüglich, um mit dem eingangs genannten Verfahren vollständig abgedichtet zu werden.

Anstelle von Polyvinylalkohol kann als Additiv für die Folie als auch für die Paste Tylose® (ein wasserlöslicher Celluloseether) oder ein anderer, vorzugsweise organischer Kunststoff verwendet werden, der teigige Konsistenz hat, Metalloxidpartikel binden und rückstandslos verdunsten oder verbrennen kann.

## Patentansprüche

1. Verfahren zum Dichten von Undichtigkeiten der zwischen den einzelnen Bauteilen eines Hochtemperatur-Brennstoffzellenstapels (2, 4) befindlichen Gasräume und/oder Gaskanäle, **dadurch gekennzeichnet**, daß mindestens zwei verschiedene Gase verwendet werden, von denen das erste zumindest eine zu einem metallionenleitenden und/oder sauerstoffionenleitenden Oxid aufoxidierbare gasförmige Verbindung enthält und das zweite sowie gegebenenfalls weitere Gase Sauerstoff enthalten und/oder abgeben können und die verschiedenen gegeneinander und nach außen abzudichtenden Gasräume (78) und/oder Gaskanäle (48 bis 55) bei hoher Temperatur dergestalt mit dem ersten, zweiten und/oder weiteren Gas beaufschlagt werden, daß jede Undichtigkeit auf der einen Seite mit dem ersten Gas und auf der anderen Seite mit dem zweiten oder weiteren Gas umspült wird, wobei das erste Gas mindestens eine oxidierbare Verbindung eines oder mehrerer der Metalle des Elektrolytmaterials, der bipolare Platte (18), der Elektroden (68, 70), der Brennstoffzelle und/oder eines der Elemente Zirkon, Nikkel, Kalzium, Magnesium, Cer oder Seltenes Erdmetall enthält.

2. Verfahren nach Anspruch 1, **dadurch gekennzeichnet**, daß den verschiedenen Gasen zur Einstellung der Reaktivität ein Inertgas, wie etwa N_{2,} oder ein Edelgas beigemischt ist.

3. Verfahren nach Anspruch 1 oder 2, **dadurch gekennzeichnet**, daß die Brennstoffzelle (2, 4) von außen mit dem ersten Gas umflutet und kathodenseitig mit dem zweiten und anodenseitig mit dem weiteren Gas durchströmt wird.

4. Verfahren nach Anspruch 3, **dadurch gekennzeichnet**, daß die Brennstoffzelle (2, 4) anodenseitig mit Wasserdampf oder mit einem Wasserdampf-Wasserstoffgas-Gemisch als weiterem Gas beaufschlagt wird.

5. Verfahren nach Anspruch 4, **dadurch gekennzeichnet**, daß die Brennstoffzelle (2, 4) anodenseitig mit einem CO- und/oder CO₂-haltigen Gas als weiterem Gas beaufschlagt wird.

6. Verfahren nach Anspruch 1 oder 2, **dadurch gekennzeichnet**, daß die Brennstoffzelle anodenseitig mit dem ersten Gas und kathodenseitig mit dem zweiten Gas beaufschlagt wird.

7. Verfahren nach einem der Ansprüche 1 bis 6, **dadurch gekennzeichnet**, daß das zweite Gas Sauerstoff enthält, dem zur Abschwächung seiner oxidativen Wirkung eine oder mehrere der Komponenten Wasserdampf, Edelgas und Stickstoff zugemischt sind.

8. Verfahren nach einem der Ansprüche 1 bis 7, **dadurch gekennzeichnet**, daß die aufoxidierbare, gasförmige Verbindung des ersten Gases eine Halogenverbindung ist.

9. Verfahren nach Anspruch 8, **dadurch gekennzeichnet**, daß das erste Gas ein Chlorid enthält.

10. Verfahren nach einem der Ansprüche 1 bis 9, **dadurch gekennzeichnet**, daß im Bereich der zu dichtenden Anlageflächen zwischen den einzelnen Bauteilen vor dem Zusammenbau der Bauteile eine Mischung (84) von Zirkonoxid, Nickel und/oder ein elektronisch besser als Zirkonoxid leitendes Oxid bzw. eine Vorstufe dazu und ein Additiv eingebracht wird und die zusammengebaute Brennstoffzelle bzw. Brennstoffzellenstapel vor bzw. während der Beaufschlagung mit dem ersten, zweiten und weiteren Gas auf Sintertemperatur aufgeheizt wird.

11. Verfahren nach Anspruch 10, **dadurch gekennzeichnet**, daß eine Paste aus Zirkonoxid, Nickel und/oder ein elektronisch besser als Zirkonoxid leitendes Oxid bzw. einer Vorstufe dazu und einem Additiv auf den zu dichtenden Anlageflächen zwischen den einzelnen Bauteilen vor dem Zusammenbau aufgetragen wird.

12. Verfahren nach Anspruch 10 oder 11, **dadurch gekennzeichnet**, daß eine hinsichtlich Form und Abmessungen deckungsgleiche, Zirkonoxid und Nickel und/ oder ein elektronisch besser als Zirkonoxid leitendes Oxid bzw. einer Vorstufe dazu und einem Additiv enthaltende Grünfolie (82) zwischen den zu dichtenden Anlageflächen vor dem Zusammenbau eingelegt wird.

13. Verfahren nach einem der Ansprüche 10 bis 12, **dadurch gekennzeichnet**, daß als Additiv Polyvinylalkohol verwendet wird.

14. Verfahren nach einem der Ansprüche 10 bis 13, **dadurch gekennzeichnet**, daß als Additiv ein wasserlöslicher Celluloseether verwendet wird.

15. Verfahren nach einem der Ansprüche 1 bis 14, **dadurch gekennzeichnet**, daß die Verfahrenstemperatur 1300 °C nicht überschreitet.

16. Verfahren nach Anspruch 15, **dadurch gekennzeichnet**, daß die Verfahrenstemperatur bei 1000 °C liegt.

17. Verfahren nach einem der Ansprüche 1 bis 16, **dadurch gekennzeichnet**, daß ein Gasdruck von etwa 10⁻³ bis 10⁻⁵ bar eingestellt wird.

18. Verfahren nach einem der Ansprüche 1 bis 17, **dadurch gekennzeichnet**, daß zeitweise der Gasdruck des ersten Gases höher ist als der des zweiten bzw. weiteren Gases und umgekehrt.

19. Verfahren nach Anspruch 18, **dadurch gekennzeichnet**, daß die Polarität der jeweiligen Druckdifferenz zwischen den beiden Gasen 1 bis 10³ Sekunden lang anhält.

20. Verfahren nach einem der Ansprüche 17 bis 19, **dadurch gekennzeichnet**, daß der Druck der beiden Gase abwechselnd stufenweise erhöht wird.

21. Verfahren nach einem der Ansprüche 1 bis 20, **dadurch gekennzeichnet**, daß die noch nicht gedichtete Brennstoffzelle (2, 4) zunächst kathodenseitig mit einem Sauerstoff-Stickstoff-Gemisch und anodenseitig mit einem Wasserstoff-Stickstoff-Gemisch gespült und dabei ca. eine Stunde lang vorgeheizt wird und erst danach der Verfahrensdruck abgesenkt und die Temperatur ganz auf Verfahrenstemperatur erhöht und zugleich die Verfahrensgase eingeleitet werden.

22. Verfahren nach Anspruch 21, **dadurch gekennzeichnet**, daß die Spülgase zur Vorheizung der Brennstoffzelle (2, 4) aufgeheizt sind.

23. Verfahren nach einem der Ansprüche 1 bis 22, **dadurch gekennzeichnet**, daß die Brennstoffzelle über eine Wirbelstromheizung aufgeheizt wird.

24. Hochtemperatur-Brennstoffzellenstapel, hergestellt nach einem der Verfahrensansprüche 1 bis 23, **dadurch gekennzeichnet**, daß im Bereich der vormals undichten Stellen (74, 76) zwischen den einzelnen Bauteilen (6, 10, 18, 20, 22, 24, 26, 28) Einlagerungen (80) aus metallionenleitenden und/oder sauerstoffionenleitenden Oxiden vorhanden sind, wobei die Einlagerungen (80) aus Oxiden wenigstens eines der Metalle des Elektrolytmaterials, der bipolaren Platte, der Elektroden, Zirkon, Nickel, Kalzium, Magnesium, Cer, Hafnium, Seltenes Erdmetall bestehen.

25. Hochtemperatur-Brennstoffzellenstapel nach Anspruch 24, **dadurch gekennzeichnet**, daß an der Innen- und/oder Außenseite von vormals undichten Stellen Auftragsschichten aus metallionenleitenden und/oder sauerstoffionenleitenden Oxiden vorhanden sind.

## Claims

1. Process for sealing leaks in the gas spaces and/or gas channels located between the individual components of a high-temperature fuel cell stack (2, 4), **characterised in that** use is made of at least two different gases, of which the first contains at least one gaseous compound that can be oxidised to form a metal ion-conducting and/or oxygen ion-conducting oxide, and the second and optionally additional gases contain and/or can give off oxygen, and the various gas spaces (78) and/or gas channels (48 to 55) that are to be sealed off from one another and towards the outside are acted upon at high temperature with the first, second and/or additional gas in such a way that any leak is bathed on one side with the first gas and on the other side with the second or additional gas, the first gas containing at least one oxidisable compound of one or more of the metals of the electrolyte material, the bipolar plate (18), the electrodes (68, 70), or the fuel cell and/or one of the elements: zirconium, nickel, calcium, magnesium, cerium or rare earth metal.

2. Process according to claim 1, **characterised in that** an inert gas, such as N₂ for instance, or a rare gas is admixed with the various gases in order to adjust the reactivity.

3. Process according to claim 1 or 2, **characterised in that** the fuel cell (2, 4) is bathed from outside with the first gas and has the second gas flowing through it on the cathode side and the additional gas flowing through it on the anode side.

4. Process according to claim 3, **characterised in that** the fuel cell (2, 4) is acted upon, on the anode side, with water vapour or with a water vapour/hydrogen gas mixture as the additional gas.

5. Process according to claim 4, **characterised in that** the fuel cell (2, 4) is acted upon, on the anode side, with a gas containing CO and/or CO₂ as the additional gas.

6. Process according to claim 1 or 2, **characterised in that** the fuel cell is acted upon, on the anode side, with the first gas and, on the cathode side, with the second gas.

7. Process according to one of claims 1 to 6, **characterised in that** the second gas contains oxygen, with which one or more of the components: water vapour, rare gas and nitrogen, are admixed in order to weaken its oxidative action.

8. Process according to one of claims 1 to 7, **characterised in that** that gaseous compound of the first gas which can be oxidised is a halogen compound.

9. Process according to claim 8, **characterised in that** the first gas contains a chloride.

10. Process according to one of claims 1 to 9, **characterised in that** there is introduced in the region of the contact faces to be sealed between the individual components, before assembly of the components, a mixture (84) of zirconium oxide, nickel and/or an oxide, or precursor thereof, having better electronic conductivity than zirconium oxide, and an additive, and the assembled fuel cell or fuel cell stack is heated up to sintering temperature before or while being acted upon with the first, second and additional gas.

11. Process according to claim 10, **characterised in that** a paste made of zirconium oxide, nickel and/or an oxide, or precursor thereof, having better electronic conductivity than zirconium oxide, and an additive, is applied to the contact faces to be sealed between the individual components, before assembly.

12. Process according to claim 10 or 11, **characterised in that** a green foil (82) which is congruent in respect of shape and dimensions and which contains zirconium oxide and nickel and/or an oxide, or precursor thereof, having better electronic conductivity than zirconium oxide, and an additive, is put in between the contact faces to be sealed, before assembly.

13. Process according to one of claims 10 to 12, **characterised in that** polyvinyl alcohol is used as the additive.

14. Process according to one of claims 10 to 13, **characterised in that** a water-soluble cellulose ether is used as the additive.

15. Process according to one of claims 1 to 14, **characterised in that** the process temperature does not exceed 1300 °C.

16. Process according to claim 15, **characterised in that** the process temperature is 1000 °C.

17. Process according to one of claims 1 to 16, **characterised in that** a gas pressure of about 10⁻³ to 10⁻⁵ bar is adjusted.

18. Process according to one of claims 1 to 17, **characterised in that** the gas pressure of the first gas is intermittently higher than that of the second or additional gas, and vice versa.

19. Process according to claim 18, **characterised in that** the polarity of the particular pressure difference between the two gases lasts for 1 to 10³ seconds.

20. Process according to one of claims 17 to 19, **characterised in that** the pressure of the two gases is increased alternately in stages.

21. Process according to one of claims 1 to 20, **characterised in that** the fuel cell (2, 4) which has not yet been sealed, is initially flushed, on the cathode side, with an oxygen/nitrogen mixture and, on the anode side, with a hydrogen/nitrogen mixture and preheated, under these circumstances, for about one hour, and only after that is the process pressure lowered and the temperature increased completely to the process temperature and the process gases conducted in at the same time.

22. Process according to claim 21, **characterised in that** the flushing gases are heated up for the purpose of preheating the fuel cell (2, 4).

23. Process according to one of claims 1 to 22, **characterised in that** the fuel cell is heated up by way of eddy current heating.

24. High-temperature fuel cell stack manufactured according to one of the process claims 1 to 23, **characterised in that** inclusions (80) made of metal ion-conducting and/or oxygen ion-conducting oxides are present in the region of the formerly leaky points (74, 76) between the individual components (6, 10, 18, 20, 22, 24, 26, 28), the inclusions (80) consisting of oxides of at least one of the metals of the electrolyte material, the bipolar plate, or the electrodes: zirconium, nickel, calcium, magnesium, cerium, hafnium, or rare earth metal.

25. High-temperature fuel cell stack according to claim 24, **characterised in that** coating layers made of metal ion-conducting and/or oxygen ion-conducting oxides are present at the inside and/or outside of formerly leaky points.

## Revendications

1. Procédé pour remédier à des défauts d'étanchéité des chambres de gaz et/ou de canaux de gaz se trouvant entre les pièces de structure individuelles d'un empilage de piles à combustible à haute température, caractérisé en ce qu'on utilise au moins deux gaz différents, parmi lesquels le premier contient au moins un composé gazeux pouvant être oxydé en un oxyde conducteur d'ions métalliques et/ou en un oxyde conducteur d'ions oxygène et le second ainsi qu'éventuellement d'autres gaz, contient(contiennent) de l'oxygène et/ou peut (peuvent) en donner, les différentes chambres (78) de gaz et/ou canaux (48 à 55) de gaz qui sont à rendre étanche l'un vis-à-vis de l'autre et vis-à-vis de l'extérieur sont alimentés en le premier, en le second et/ou en d'autres gaz à haute température de sorte que tout défaut d'étanchéité soit baigné d'un côté par le premier gaz et de l'autre côté par le second ou les autres gaz, le premier gaz comportant au moins un composé pouvant être oxydé d'un ou de plusieurs des métaux choisis dans le groupe constitué du matériau d'électrolyte, du matériau de la plaque (18) bipolaire, du matériau des électrodes (68, 70), du matériau de la pile de combustible et/ou d'un élément choisi parmi le zirconium, le nickel, le calcium, le magnésium, le cérium ou un métal des terres rares.

2. Procédé suivant la revendication 1, caractérisé en ce qu'un gaz inerte, comme par exemple N2, ou un gaz noble est mélangé aux différents gaz pour ajuster la réactivité.

3. Procédé suivant la revendication 1 ou 2, caractérisé en ce que la pile (2, 4) de combustible baigne à l'extérieur dans le premier gaz et un courant du second gaz passe du côté de la cathode et un courant de l'autre gaz passe du côté de l'anode.

4. Procédé suivant la revendication 3, caractérisé en ce que la pile (2, 4) de combustible est alimentée du côté de l'anode en vapeur d'eau ou d'un mélange de vapeur d'eau-hydrogène gazeux en tant que gaz supplémentaire.

5. Procédé suivant la revendication 4, caractérisé en ce que la pile (2, 4) de combustible est alimentée du côté de l'anode en un gaz contenant du CO et/ou du CO₂ en tant que gaz supplémentaire.

6. Procédé suivant la revendication 1 ou 2, caractérisé en ce que la pile de combustible est alimentée du côté de l'anode en le premier gaz et du côté de la cathode en le second gaz.

7. Procédé suivant l'une des revendications 1 à 6, caractérisé en ce que le second gaz comporte de l'oxygène, un ou plusieurs des composants constitués de vapeur d'eau, de gaz noble et d'azote étant mélangé à celui-ci pour diminuer son effet d'oxydation.

8. Procédé suivant l'une des revendications 1 à 7, caractérisé en ce que le composé gazeux pouvant être oxydé du premier gaz est un composé halogéné.

9. Procédé suivant la revendication 8, caractérisé en ce que le premier gaz contient un chlorure.

10. Procédé suivant l'une des revendications 1 à 9, caractérisé en ce que dans la région des surfaces d'application à rendre étanche entre les différentes parties de structure, on apporte avant l'assemblage des pièces de structure un mélange (84) d'oxyde de zirconium, de nickel et/ou d'un oxyde meilleur conducteur de l'électricité que l'oxyde de zirconium et un précurseur de celui-ci et un additif, et la pile de combustible assemblée ou l'empilage de piles de combustible est chauffé à la température de frittage avant ou pendant l'amenée du premier, du second et des autres gaz.

11. Procédé suivant la revendication 10, caractérisé en ce qu'une pâte en oxyde de zirconium, nickel et/ou un oxyde meilleur conducteur de l'électricité que l'oxyde de zirconium, ou un précurseur de celle-ci et un additif sont appliqués aux surfaces d'application à rendre étanche entre les pièces de structure individuelles avant l'assemblage.

12. Procédé suivant la revendication 10 ou 11, caractérisé en ce qu'une feuille (82) à vert contenant de l'oxyde de zirconium et du nickel et/ou un oxyde meilleur conducteur de l'électricité que l'oxyde de zirconium ou un précurseur de celui-ci et un additif est inséré en coïncidence du point de vue de la forme et des dimensions entre les surfaces d'application à rendre étanche avant l'assemblage.

13. Procédé suivant l'une des revendications 10 à 12, caractérisé en ce qu'on utilise un alcool de polyvinyle en tant qu'additif.

14. Procédé suivant l'une des revendications 10 à 13, caractérisé en ce qu'on utilise un éther de cellulose soluble dans l'eau en tant qu'additif.

15. Procédé suivant l'une des revendications 1 à 14, caractérisé en ce que la température opératoire ne dépasse pas 1300°C.

16. Procédé suivant la revendication 15, caractérisé en ce que la température opératoire est à 1000°C.

17. Procédé suivant l'une des revendications 1 à 16, caractérisé en ce que l'on établit une pression gazeuse d'environ 10⁻³ à 10⁻⁵ bar.

18. Procédé suivant l'une des revendications 1 à 17, caractérisé en ce que la pression gazeuse du premier gaz est supérieure à la pression gazeuse du second ou des autres gaz pendant un certain temps puis cela est inversé.

19. Procédé suivant la revendication 18, caractérisé en ce que la polarité des pertes de charge respectives entre les deux gaz durent de 1 à 103 secondes.

20. Procédé suivant l'une des revendications 17 à 19, caractérisé en ce que la pression des deux gaz est augmentée par étapes en alternance.

21. Procédé suivant l'une des revendications 1 à 20, caractérisé en ce que la pile (2, 4) de combustible qui n'est pas encore rendue étanche est d'abord baignée du côté de la cathode par un mélange d'azote et d'oxygène et du côté de l'anode par un mélange d'azote et d'hydrogène et est ensuite préchauffée pendant 1 heure et ce n'est qu'ensuite que l'on abaisse la pression opératoire, on augmente la température à la température opératoire et simultanément on envoie les gaz du procédé.

22. Procédé suivant la revendication 21, caractérisé en ce que les gaz de bain sont chauffés pour le préchauffage de la pile (2, 4) de combustible.

23. Procédé suivant l'une des revendications 1 à 22, caractérisé en ce que la pile de combustible est chauffée par un chauffage à courant de Foucault.

24. Empilage de piles à combustible à haute température, fabriqué suivant l'une des revendications de procédé 1 à 23, caractérisé en ce que dans la région des points (74, 76) qui étaient auparavant non étanches entre les pièces (6, 10, 18, 20, 22, 24, 26, 28) de structure individuelle sont prévus des inserts (80) en un oxyde conducteur d'ions métalliques et/ou conducteur d'ions oxygènes, les inserts (80) étant constitués d'oxydes d'au moins un des métaux choisis parmi les métaux du matériau d'électrolyte, de la plaque bipolaire, des électrodes, le zirconium, le nickel, le calcium, le magnésium, le cérium, l'hafnium et d'un métal des terres rares.

25. Empilage de piles à combustible à haute température suivant la revendication 24, caractérisé en ce que du côté intérieur et/ou extérieur des points qui étaient auparavant non étanches, sont prévues des couches de support en des oxydes conducteurs d'ions métalliques et/ou conducteurs d'ions oxygènes.
